# EUROPÄISCHE PATENTSCHRIFT

(11) **EP 3 826 159 B1**
(45) Veröffentlichungstag und Bekanntmachung des Hinweises auf die Patenterteilung: **08.05.2024**
(21) Anmeldenummer: 20185405.6
(22) Anmeldetag: 13.07.2020
(51) Int. Cl.: H02M 1/42, H02M 7/487

(54) **VORRICHTUNG ZUR EFFIZIENTEN NETZARTUNABHÄNGIGEN ZWISCHENKREISAUFBEREITUNG**
DEVICE FOR EFFICIENT NETWORK-INDEPENDENT INTERMEDIATE CIRCUIT PROCESSING
DISPOSITIF DE TRAITEMENT RÉGULÉ DU CIRCUIT INTERMÉDIAIRE EFFICACE INDÉPENDAMMENT DU TYPE DE RÉSEAU

(30) Priorität: 21.11.2019 DE 102019131410
(43) Veröffentlichungstag der Anmeldung: 26.05.2021
(73) Patentinhaber: ebm-papst Mulfingen GmbH & Co. KG, 74673 Mulfingen (DE)
(72) Erfinder: BÜRKERT, Martin, 74677 Dörzbach-Hohebach (DE); SCHNEIDER, Fabian, 74585 Rot am See (DE); SCHNEIDER, Alex, 74653 Künzelsau (DE); WAGNER, Fabian, 74214 Oberkessach (DE); HANSELMANN, Steffen, 74532 Ilshofen (DE)
(74) Vertreter: Staeger & Sperling Partnerschaftsgesellschaft mbB

(56) Entgegenhaltungen:
- WO-A-2019/186078
- WO-A1-2019/186078
- DE-A1- 4 305 768
- DE-C2- 4 305 768
- FR-A1- 2 921 211
- US-A1- 2019 288 539

## Beschreibung

Die vorliegende Erfindung beschäftigt sich mit der effizienten netzartunabhängigen Zwischenkreisaufbereitung bei gleichzeitiger Reduzierung der Oberschwingungsanteile im Eingangsstrom, d. h. zur Verwendbarkeit bzw. Anwendbarkeit in unterschiedlichen Versorgungsnetzen, insbesondere in einphasigen und dreiphasigen Netzen.

Aus dem Stand der Technik sind unterschiedliche Konzepte bekannt, um die Zwischenkreisaufbereitung bei unterschiedlichen Versorgungsnetzarten zu realisieren.

So ist zum Beispiel aus der EP 0696838 B1 eine mehrphasige Gleichrichterbrückenschaltung für einen einphasigen Eingang bekannt. Die EP 3324535 B1 beschäftigt sich mit einem elektronisch kommutierten Gebläsesystem. Aus der EP 3509212A1 ist ein Motorantriebs-Leistungsumwandlungssystem bekannt, einschließlich einer Filterschaltung mit einer einzelnen Induktivität und einem Kondensator für jede Eingangsphase, eines aktiven Gleichrichters mit Siliziumkarbid-Gleichrichterschaltvorrichtungen, einer Gleichstrom-Zwischenkreisschaltung mit einem Film-Gleichstrom-Zwischenkreiskondensator, einem Wechselrichter sowie einer Steuerung, um die Gleichrichterschaltvorrichtungen mit einer PWM-Gleichrichterschaltfrequenz von 10 kHz oder mehr zu betreiben.

Aus der US 2007 004 0516 A1 ist ferner ein Wechselstrom-Gleichstrom-Wandler mit PFC bekannt, der eine konstante Ausgangsspannung bei einem beliebigen vorbestimmten Wert (egal ob weniger oder mehr als die Eingangsleitungsspitzenspannung oder sogar gleich der Eingangsleitungsspitzenspannung) mit einer Eingangsleitungswechselspannung mit breitem Spannungsbereich (typisch sinusförmig 110 VAC, 60 Hz oder 220 VAC, 50 Hz) bereitstellt.

Aus der FR 2 921 211 A1 ist ferner eine Schaltungsanordnung nach dem Oberbegriff des Anspruchs 1 bekannt.

Die aus dem Stand der Technik bekannten Systeme zeigen allerdings zumindest einen der nachfolgenden genannten Nachteile oder Probleme, die es zu verbessern oder beseitigen gilt:
a) Zu hohe Oberschwingungsgehalte des Aufnahmestromes;
b) Keine netzartunabhängige Aufbereitung der Zwischenkreisspannung möglich;
c) Keine Möglichkeit die Zwischenkreisspannungshöhe abhängig von der Last zur Verfügung stellen zu können;
d) Unsymmetrische Belastung der Netzphasen;
e) Keine Möglichkeit der Reduktion der Elektronikvarianz;
f) Hohe Werkzeugkosten und/oder Entwicklungskosten für Design und Herstellung;
g) Hohe Lagerkosten aufgrund der Variantenvielfalt.

Der Erfindung liegt deshalb die Aufgabe zugrunde, vorbesagte Nachteile zu überwinden und eine kostengünstig herstellbare Lösung zu schaffen, mit der eine effiziente netzartunabhängige Zwischenkreisaufbereitung bei insbesondere einer Reduktion der Oberschwingungsanteile im Eingangsstrom realisierbar ist.

Diese Aufgabe wird durch die Merkmalskombination gemäß Patentanspruch 1 gelöst.

Eine Grundidee ist dabei ein Konzept mit einem veränderbaren Netzanschluss einer 3-Phasen-PFC-Topologie und so Auszubilden, dass eine Anpassung der Ansteuerung möglich ist, so dass sich die Drehstrom- PFC-Topologie auch für einen 1-Phasigen Netzanschluss bei gleicher Abgabeleistung einsetzen lässt.

Erfindungsgemäß wird hierzu eine Schaltungsanordnung für einen im Hinblick auf die Eingangsspannung veränderbaren Netzanschluss (1-phasig/3-phasig) aufweisend eine 3-phasige PFC-Stufe vorgeschlagen, deren Mittelabgriff, der zwischen den Kondensatoren über eine Verbindungsleitung mit einem Neutralleiter der Eingangs-Wechselspannungsquelle verbunden ist, wobei zur Realisierung des 1-Phasenbetriebs in jedem Leitungszweig der PFC-Stufe parallel zu den Gleichrichterdioden ein Zweig mit je zwei weiteren in Serie geschalteten Dioden geschaltet ist und jeweils ein Mittelabgriff, der zwischen mit dem Neutralleiter verbunden ist, während der Mittelabgriff, der zwischen den Kondensatoren nicht mit dem Neutralleiter über die Verbindungsleitung verbunden ist. Diese

Schaltungstopologie weist die Eigenschaft in einem 1-phasigen Netzbetrieb auf, die gleichgerichtete Spannung zu verdoppeln, um diese anschließend auf die zu regelende Spannungshöhe einzustellen.

Der 3-Phasige Betrieb an den Phasen (L1, L2, L3) der Eingangs-Wechselspannungsquelle erfolgt dabei in einer ersten Schaltungstopologie und der 1-Phasige Betrieb durch Zusammenschalten der Phasenanschlüsse (L1, L2, L3) in Parallelschaltung und sowie vorzugsweise weiterer Modifikation der Schaltung, wie dies in den nachfolgenden bevorzugten Ausführungsvarianten beschrieben wird.

Somit verfügt die genannte Schaltungsanordnung grundsätzlich über Umschaltmittel bzw. Anpassungsmittel zum bestimmungsgemäßen Herstellen einer Topologie für einen 3-Phasenbetrieb und alternativ dem 1-Phasenbetrieb.

Eine solche besteht aus den zwei Dioden und den zwei in Reihe geschalteten Kapazitäten. Die Spannungsquelle wird dann zwischen den beiden Dioden und auf dem Mittelabriff der Kapazitäten gelegt. Durch diese Verschaltung lädt die positive Halbwelle des Netzes die obere Kapazität und die negative Halbwelle die untere Kapazität. Über beide Kondensatoren liegt so die doppelte gleichgerichtete Versorgungsspannung an.

Es wird in einer bevorzugten Ausgestaltung vorgesehen, dass in der Verbindungsleitung zwischen dem Spannungsdopplerschaltung und dem Neutralleiteranschluss ein Schalter vorgesehen ist, um die Verbindung für eine Umschaltung von einem 1-Phasen in einen 3-Phasen Betrieb wahlweise trennen oder schließen zu können.

Weiter ist mit Vorteil vorgesehen, dass zwischen der Eingangs-Wechselspannungsquelle und der PFC-Stufe eine Spannungsauswerteeinrichtung vorgesehen ist und der Schaltzustand (Offen/Geschlossen) des zuvor genannten Schalters von der Spannungsauswerteeinrichtung gesteuert wird.

In einer weiteren bevorzugten Ausgestaltung der Erfindung ist vorgesehen, dass im 3-Phasenbetrieb die drei Phasenanschlüsse (L1, L2, L3) jeweils mit einem der Eingänge der PFC-Stufe verbunden sind, während im 1-Phasenbetrieb die drei Phasenanschlüsse (L1, L2, L3) miteinander verbunden werden und über einen Mittelabgriff der Kondensatoren über die besagte Verbindungsleitung mit dem Neutralleiteranschluss zur Verbindung mit dem Neutralleiter der Wechseleingangsspannungsquelle verbunden werden.

Die dazu vorgesehenen Umschaltmittel Herstellung der im Absatz zuvor genannten Verbindung kann über ein dazu angebrachtes Kabel, eine Drahtbrücke oder eine Verbindungsleitung entweder manuell oder automatisch durch Auswerten der Eingangsspannung erfolgen, wozu für die Automation die Eingangsspannung ausgewertet wird und bei Erfassen einer 1-Phasen-Versorgung, wird der Mittelabgriff der Kondensatoren mit dem N-Leiter über einen elektrischen Schalter/Relais verbunden. Wird hingegen eine 3-Phasen Versorgung detektiert, bleibt der Schalter geöffnet.

Weiter Vorteilhaft ist es, wenn vor der PFC-Stufe ein in der Filtercharakteristik anpassbarer EMV-Filter vorgesehen ist, dessen Anpassung der Filtercharakteristik je nach 1-Phasen oder 3-Phasenbetrieb vorzugsweise über mehrere Stromkompensationsdrosseln realisiert ist.

In einer bevorzugten Ausgestaltung der Erfindung ist die 3-phasige PFC Stufe als Vienna-Rectifier ausgebildet. Allerdings lassen sich (wie nachfolgend bei der Beschreibung der Ausführungsbeispiele gezeigt) auch andere PFC-Stufen realisieren.

In jedem Leitungszweig der PFC-Stufe können sechs Dioden und je ein elektrischer Schalter vorgesehen werden, sowie die dazu parallel in Reihe geschaltete Kapazitäten zwischen denen der Mittelabgriff ausgebildet ist, der mit dem Neutralleiter der Eingangswechselspannungsquelle verbunden bzw. verbindbar ist.

In einer bevorzugten Ausgestaltung der Erfindung ist vorgesehen, dass zur Realisierung des 1-Phasenbetriebs in jedem Leitungszweig der PFC-Stufe parallel zu den Gleichrichterdioden ein Zweig mit je zwei weiteren in Serie geschalteten Dioden vorgesehen ist und dazwischen mit dem Neutralleiter verbunden ist, während der weiter oben genannte Mittelabgriff zwischen den Kondensatoren allerdings dann nicht mit dem Neutralleiter über die Verbindungsleitung und jeweils dem Mittelabgriff verbunden ist. Durch dieses Vorgehen wird die Spannungsverdopplung gezielt verhindert, um auch Verbraucher mit kleineren Spannungsregelungen kommutieren zu können.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt.

Es zeigen:
- Fig. 1: eine Schaltungstopologie eines Vienna-Rectifiers als PFC-Stufe zur Realisierung eines ersten Ausführungsbeispiels einer Schaltung, die nicht Teil der Efindung ist;
- Fig. 2: eine schematische Ansicht, welche das Grundprinzip der Erfindung verdeutlicht,
- Fig. 3: ein alternatives Ausführungsbeispiel einer Schaltung, die nicht Teil der Efindung ist;
- Fig. 4: ein weiteres alternatives Ausführungsbeispiel einer Schaltung, die nicht Teil der Erfindung ist;
- Fig. 5: ein weiteres alternatives Ausführungsbeispiel einer Schaltung, die nicht Teil der Erfindung ist;
- Fig. 6: ein weiteres alternatives Ausführungsbeispiel einer Schaltung, die nicht Teil der Erfindung ist;
- Fig. 7: ein Ausführungsbeispiel einer erfindungsgemäßen Schaltung ohne Spannungsverdopplung.

Im Folgenden wird die Erfindung mit Bezug auf die Figuren näher erläutert, wobei gleiche Bezugszeichen in den unterschiedlichen Ausführungsbeispielen auf gleiche strukturelle und/oder funktionale Merkmale hinweisen.

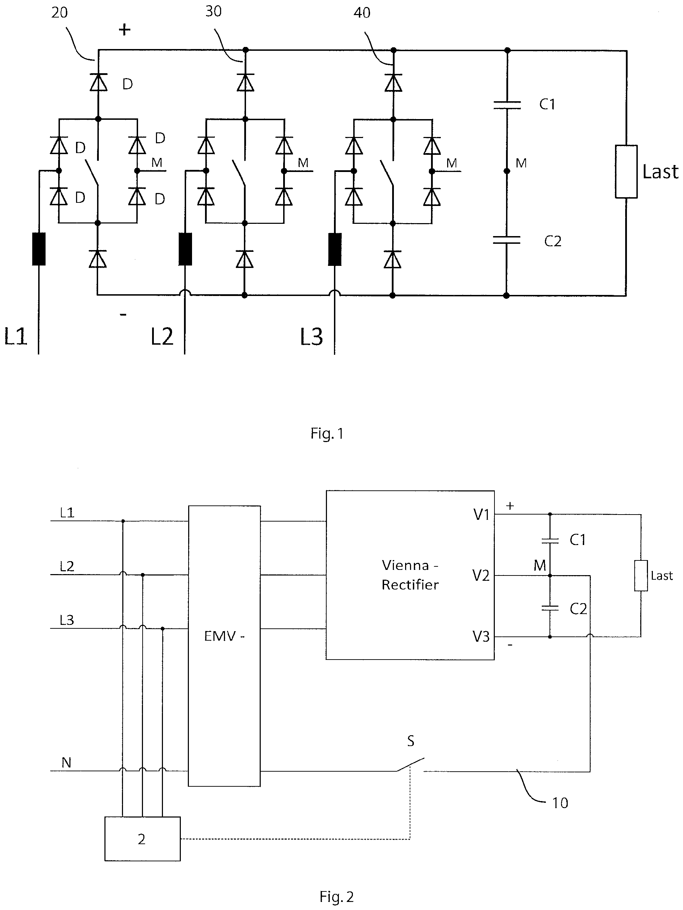

In der Fig. 1 ist zunächst eine beispielhafte Schaltungstopologie eines Vienna-Rectifiers als PFC-Stufe zur Realisierung eines ersten Ausführungsbeispiels einer Schaltung 1 gezeigt. Der Vienna Rectifier besteht dabei aus drei Zweigen 20, 30, 40, nämlich für jede Phase L1, L2, L3 einen Leitungszweig. Ein Leitungszweig 20, 30, 40 wird aus sechs Dioden D und je einem elektrischen Schalter Sz (z. B. MOSFET, IGBT,...) realisiert. Über in Reihe geschaltete Kapazitäten C1, C2 wird der Mittelabgriff M angebunden. Durch geeignetes Takten der elektrischen Schalter Sz werden die Kapazitäten C1, C2 mit Mittelabgriff M symmetrisch geladen, sodass ein synchroner sinusförmiger Strom dem Netz entnommen werden kann.

Die Fig. 2 zeigt eine schematische Ansicht, welche das Grundprinzip der Erfindung verdeutlicht. Links in der Abbildung sind die Phasenanschlüsse L1, L2, L3 sowie der Neutralleiteranschluss N zu erkennen. Dahinter befindet sich die 3-phasige PFC-Stufe (hier als Vienna-Rectifier) ausgebildet, deren Ausgänge V1, V2, V3 mit den zwei Kondensatoren C1, C2 verbunden sind, wobei der Mittelabgriff M mit dem Ausgang V2 der PFC-Stufe verbunden ist und dieser Mittelabgriff M zwischen den Kondensatoren C1, C2 über eine Verbindungsleitung 10 mit dem Neutralleiteranschluss N einer Eingangs-Wechselspannungsquelle verbunden ist. Ferner ist der Anschluss einer beispielhaften Last gezeigt.

In der Verbindungsleitung 10 ist ein Schalter S vorgesehen. Ferner ist zwischen der Eingangs-Wechselspannungsquelle bzw. den Anschlüssen L1, L2, L3 und N und der PFC-Stufe eine Spannungsauswerteeinrichtung 2 vorgesehen. Der Schaltzustand (Offen/Geschlossen) des Schalters S wird von der Spannungsauswerteeinrichtung 2 gesteuert.

Vor der PFC-Stufe befindet sich ein in der Filtercharakteristik anpassbarer EMV-Filter (EMV), dessen Filtercharakteristik vorzugsweise über Stromkompensationsdrosseln realisiert ist. Dazu werden eine oder mehrere 4-Phasen-Stromkompensationsdrosseln eingesetzt, abhängig von der Filterstufe. Im 3-Phasen Betrieb wirken diese wie eine 3-Phasen Stroko, da der N-Leiter dann nicht angeschlossen ist. Im 1-Phasen Betrieb werden diese drei Wicklungen parallel bestromt. Über die vierte Wicklung im N-Leiter läuft dann der Gesamtstrom zurück.

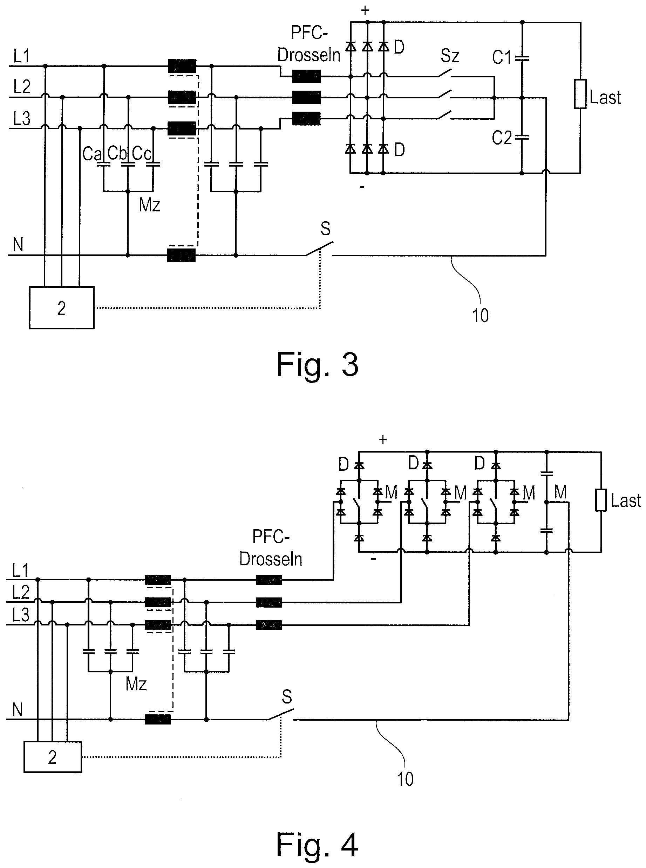

In der Fig. 3 findet sich ein Ausführungsbeispiel einer Schaltung. Prinzipiell ist die gezeigte PFC-Stufe mit sechs Dioden D und drei elektronischen Schaltern Sz aufgebaut. Die Schalter Sz sind in dieser Topoologie direkt mit dem Mittelabgriff M verbunden.

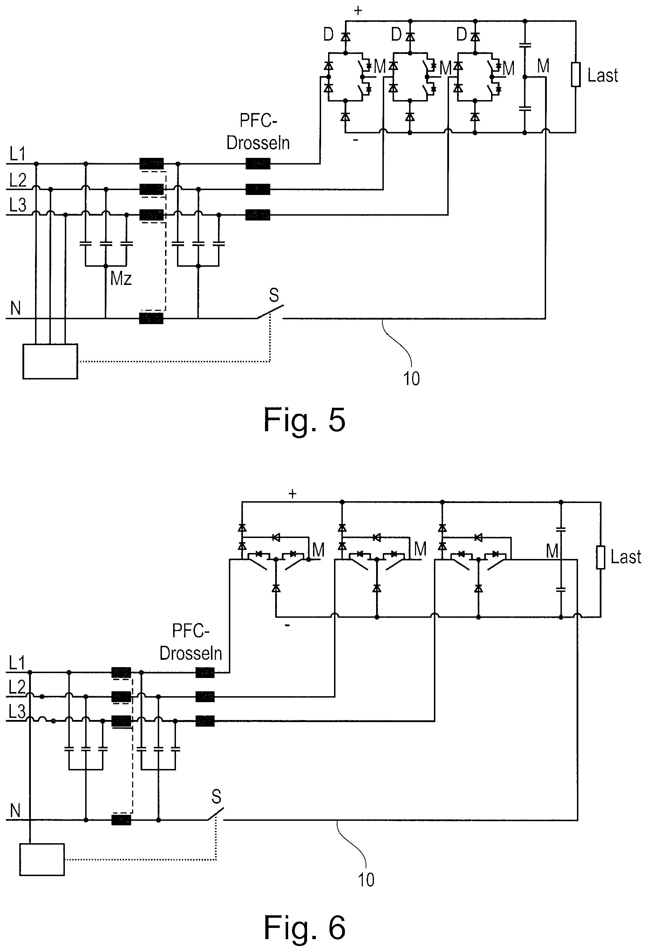

Die Grundfunktion der Schalter Sz lässt sich durch unterschiedliche Ausführungen, wie nachfolgend beschrieben realisieren. Als Beispiele werden folgende Topologien der Figuren 4 bis 6 gezeigt.

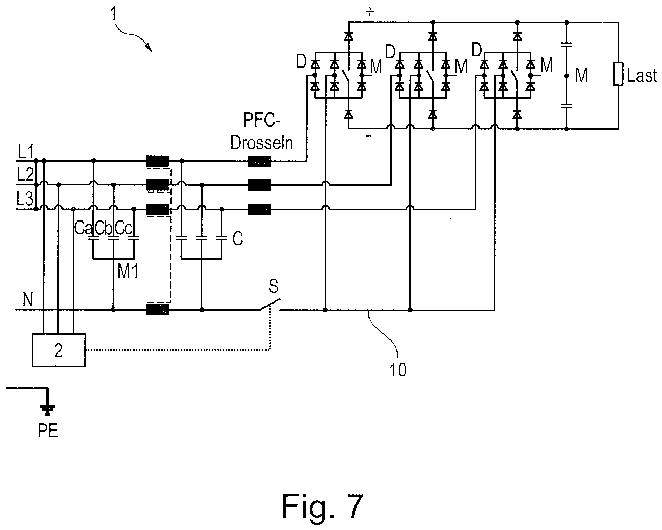

In der Ausführung der Figur 7 ist erläutert, wie der 1-Phasenbetrieb bevorzugt realisiert wird. Hierzu sind die drei Phasenanschlüsse L1, L2, L3 miteinander mit den drei Kondensatoren Ca, Cb, Cc verbunden. Der Mittelabgriff wird mit M1 bezeichnet. Die Verbindungsleitung 10 ist dabei mit dem Neutralleiter N der Wechseleingangsspannungsquelle verbunden. Soll hingegen keine Spannungsdopplung im einphasigen Betrieb auftreten, muss die Schaltung noch mit zusätzlichen Dioden nach Figur 7 angepasst werden. Pro Zweig werden dazu zwei weitere Dioden benötigt. Diese werden parallel zu den bereits vorhandenen Gleichrichterdioden angeschlossen. Der Neutralleiter N wird hier nicht auf den Kondensatorenmittelabgriff zwischen den Kondensatoren C1 und C2, sondern auf den jeweils gemeinsamen Anschluss Mz.

## Patentansprüche

1. Schaltungsanordnung (1) für einen im Hinblick auf die Eingangsspannung veränderbaren Netzanschluss (1-phasig/3-phasig) aufweisend eine 3-phasige PFC-Stufe und einen Mittelabgriff (M), der zwischen den Kondensatoren (C) über eine Verbindungsleitung (10) mit einem Neutralleiter (N) einer Eingangs-Wechselspannungsquelle verbunden ist, **dadurch gekennzeichnet, dass** zur Realisierung des 1-Phasenbetriebs in jedem Leitungszweig (20, 30, 40) der PFC-Stufe parallel zu den Gleichrichterdioden ein Zweig mit je zwei weiteren in Serie geschalteten Dioden geschaltet ist und zwischen den Dioden jeweils ein Mittelabgriff vorgesehen ist, der mit dem Neutralleiter (N) verbunden ist, während der Mittelabgriff (M), der zwischen den Kondensatoren (C) vorgesehen ist, nicht mit dem Neutralleiter (N) über die Verbindungsleitung (10) verbunden ist.

2. Schaltungsanordnung (1) gemäß Anspruch 1, **dadurch gekennzeichnet, dass** in der Verbindungsleitung (10) ein Schalter (S) vorgesehen ist.

3. Schaltungsanordnung (1) gemäß Anspruch 2, **dadurch gekennzeichnet, dass** zwischen der Eingangs-Wechselspannungsquelle und der PFC-Stufe eine Spannungsauswerteeinrichtung (2) vorgesehen ist und der Schaltzustand (Offen/Geschlossen) des Schalters (S) von der Spannungsauswerteeinrichtung (2) gesteuert wird.

4. Schaltungsanordnung (1) gemäß einem der Ansprüche 1 bis 3, **dadurch gekennzeichnet, dass** im 3-Phasenbetrieb die Phasen (L1, L2, L3) jeweils mit der PFC-Stufe verbunden sind, während im 1-Phasenbetrieb die drei Phasenanschlüsse (L1, L2, L3) miteinander in Parallelschaltung über drei Kondensatoren (Ca, Cb, Cc) verbunden werden und über einen Mittelabgriff (M1) der Parallelschaltung über die Verbindungsleitung (10) mit dem Neutralleiter (N) der Wechseleingangsspannungsquelle verbunden werden.

5. Schaltungsanordnung (1) gemäß Anspruch 4, **dadurch gekennzeichnet, dass** die Herstellung der Verbindung über ein dazu angebrachtes Kabel, eine Drahtbrücke oder eine Verbindungsleitung entweder manuell oder automatisch durch Auswerten der Eingangsspannung erfolgt.

6. Schaltungsanordnung (1) gemäß einem der vorhergehenden Ansprüche, **dadurch gekennzeichnet, dass** vor der PFC-Stufe ein in der Filtercharakteristik anpassbarer EMV-Filter (EMV) vorgesehen ist, dessen Filtercharakteristik vorzugsweise über mehrere Stromkompensationsdrosseln realisiert ist.

7. Schaltungsanordnung (1) gemäß einem der vorhergehenden Ansprüche, **dadurch gekennzeichnet, dass** die 3-phasige PFC Stufe ein Vienna-Rectifier mit parallel angeordneten Dioden darstellt.

8. Schaltungsanordnung (1) gemäß einem der vorhergehenden Ansprüche, **dadurch gekennzeichnet, dass** in jedem Leitungszweig (20, 30, 40) sechs Dioden (D) und je ein elektrischer Schalter (S) vorgesehen ist, sowie parallel dazu in Reihe geschaltete Kapazitäten (C1, C2) zwischen denen ein Mittelabgriff (M) ausgebildet ist, der mit dem Neutralleiter (N) der Eingangswechselspannungsquelle verbunden ist.

## Claims

1. A circuit arrangement (1) for a network connection variable with regard to the input voltage (1-phase/3-phase), comprising a 3-phase PFC stage and a centre tap (M) connected between the capacitors (C) via a connecting line (10) to a neutral conductor (N) of an input AC voltage source, **characterized in that**, to implement the 1-phase mode, a branch having two further diodes connected in series is connected in parallel to the rectifier diodes in each line branch (20, 30, 40) of the PFC stage and between the diodes a centre tap (M) is provided respectively, which is connected to the neutral conductor (N), while the centre tap (M) provided between the capacitors (C) is not connected to the neutral conductor (N) via the connecting line (10).

2. The circuit arrangement (1) as claimed in claim 1, **characterized in that** a switch (S) is provided in the connecting line (10).

3. The circuit arrangement (1) as claimed in claim 2, **characterized in that** a voltage analysis unit (2) is provided between the input AC voltage source and the PFC stage and the switching state (open/closed) of the switch (S) is controlled by the voltage analysis unit (2).

4. The circuit arrangement (1) as claimed in any one of claims 1 to 3, **characterized in that**, in the 3-phase mode, the phases (L1, L2, L3) are each connected to the PFC stage, while in the 1-phase mode, the three phase connections (L1, L2, L3) are connected to one another in a parallel circuit via three capacitors (Ca, Cb, Cc) and are connected via a centre tap (M1) of the parallel circuit via the connecting line (10) to the neutral conductor (N) of the AC input voltage source.

5. The circuit arrangement (1) as claimed in claim 4, **characterized in that** the establishment of the connection is performed via a cable, a wire bridge, or a connecting line, attached for this purpose, either manually or automatically by analysis of the input voltage.

6. The circuit arrangement (1) as claimed in any one of the preceding claims, **characterized in that** an EMC filter (EMC) adaptable in the filter characteristic is provided before the PFC stage, the filter characteristic of which is preferably implemented via multiple current compensation chokes.

7. The circuit arrangement (1) as claimed in any one of the preceding claims, **characterized in that** the 3-phase PFC stage represents a Vienna rectifier having diodes arranged in parallel.

8. The circuit arrangement (1) as claimed in any one of the preceding claims, **characterized in that** six diodes (D) and one electrical switch (S) are provided in each line branch (20, 30, 40), and also parallel capacitors (C1, C2) connected in series thereto, between which a centre tap (M) is formed, which is connected to the neutral conductor (N) of the input AC voltage source.

## Revendications

1. Agencement de circuit (1) pour une connexion secteur (monophasée/triphasée) modifiable en fonction de la tension d'entrée, comportant un étage PFC triphasé et une prise centrale (M) qui est connectée entre les condensateurs (C) via un câble de connexion (10) à un conducteur neutre (N) d'une source de tension alternative d'entrée, **caractérisé en ce que** pour mettre en oeuvre un fonctionnement monophasé dans chaque branche de circuit (20, 30, 40) de l'étage PFC, une branche avec deux autres diodes montées en série est montée parallèlement aux diodes de redressement et entre les deux autre diodes une prise centrale est montée, qui est connectée au conducteur neutre (N), tandis que la prise centrale (M) qui est prévue entre les condensateurs (C), n'est pas connectée au conducteur neutre (N) via le câble de connexion (10).

2. Agencement de circuit (1) selon la revendication 1, **caractérisé en ce qu'**un commutateur (S) est prévu dans le câble de connexion (10).

3. Agencement de circuit (1) selon la revendication 2, **caractérisé en ce qu'**un dispositif d'évaluation de tension (2) est prévu entre la source de tension alternative d'entrée et l'étage PFC, et l'état de commutation (ouvert/fermé) du commutateur (S) est commandé par le dispositif d'évaluation de tension (2).

4. Agencement de circuit (1) selon l'une des revendications 1 à 3, **caractérisé en ce qu'**en fonctionnement triphasé les phases (L1, L2, L3) sont connectées chacune à l'étage PFC, tandis qu'en fonctionnement monophasé les trois connexions de phase (L1, L2, L3) sont connectées entre elles en parallèle via trois condensateurs (Ca, Cb, Cc) et sont connectées via une prise centrale (M1) du circuit en parallèle via le câble de connexion (10) au conducteur neutre (N) de la source de tension d'entrée alternative.

5. Agencement de circuit (1) selon la revendication 4, **caractérisé en ce que** la connexion est établie via un câble qui lui est fixé, un pont métallique ou un câble de connexion soit manuellement, soit automatiquement par évaluation de la tension d'entrée.

6. Agencement de circuit (1) selon l'une des revendications précédentes, **caractérisé en ce qu'**il est prévu en amont de l'étage PFC un filtre CEM (EMV) ajustable au niveau de la caractéristique de filtre, et dont la caractéristique de filtre est de préférence mise en oeuvre via plusieurs étranglements de compensation de courant.

7. Agencement de circuit (1) selon l'une des revendications précédentes, **caractérisé en ce que** l'étage PFC triphasé représente un redresseur de Vienne à diodes disposées en parallèle.

8. Agencement de circuit (1) selon l'une des revendications précédentes, **caractérisé en ce que** dans chaque branche de circuit (20, 30, 40) sont prévus six diodes (D) et un commutateur électrique (S), ainsi que des capacités (C1, C2), montées en parallèle à ceux-ci, entre lesquelles est formée une prise centrale (M), qui est connectée au conducteur neutre (N) de la source de tension alternative d'entrée.
